# EUROPEAN PATENT APPLICATION

(11) **EP 3 422 430 A1**
(43) Date of publication of application: **02.01.2019**
(21) Application number: 17382397.2
(22) Date of filing: 26.06.2017
(51) Int. Cl.: H01L 51/44, H01G 9/20

(54) **ELECTRODE FOR A PEROVSKITE-BASED PHOTOELECTROCHEMICAL DEVICE**

(71) Applicant: Universitat Jaume I de Castello, 12071 Castellón de la Plana (ES)
(72) Inventor: GUERRERO CASTILLEJO, Antonio, 12006 CASTELLÓN (ES); BISQUERT MASCARELL, Juan, 46022 VALENCIA (ES)
(74) Representative: Pons

(57) **Abstract**

The present invention relates to an electrode for a photoelectrochemical device which comprises an aqueous solution, said electrode being based on a perovskite photovoltaic film. In particular, the electrode of the invention comprises a protective film of said perovskite against the aqueous solution. Additionally, the protective layer includes a catalyst for carrying out oxidation-reduction reactions that can be used to transform solar energy into chemical energy. Therefore, the invention can be classified in the energy sector, where electricity, fuels, etc., may be obtained from sunlight.

## Description

The present invention relates to an electrode for a photoelectrochemical device which comprises an aqueous solution, said electrode being based on a perovskite photovoltaic film. In particular, the electrode of the invention comprises a protective film of said perovskite against the aqueous solution. Additionally, the protective layer includes a catalyst to carry out oxidation-reduction reactions that can be used to transform solar energy into chemical energy. Therefore, the invention can be classified in the energy sector where electricity, fuels, etc., can be obtained from sunlight.

### STATE OF THE ART

The "hybrid (or inorganic) perovskite" semiconductors which have been used in photovoltaics include the chemical formula ABX₃, where A is an organic (MA=methylammonium or FA=formamidinium,...) or inorganic (Cs,...) cation, B is a metal cation (Pb, Sn,...) and X is a halogen (X=I, Br, Cl). In a cell unit of the idealised cubic perovskite crystal structure, A is positioned on the vertices of a cube, B is positioned in the center of the cube and X is positioned in the center of each of the sides of the cube, giving rise to octahedrons upon coordinating with B.

Various formulations can be used where different A cations are mixed in different proportions. Likewise, B cations and X anions can also be combined. The devices which have the most efficient in a photovoltaic setup mix various cations and anions in their composition: MA/FA/Cs/Rb/pb/I/Br. Hybrid semiconductors based on lead halides with organic cations have shown exceptional photovoltages in solar cell setup (1.0-1.4 V) with high photocurrents (≈20 mA/cm²), but this photovoltage has not yet been used to date in photoelectrochemical setup in aqueous solutions due to the high reactivity of this type of perovskite with water. There are only two examples in the bibliography where a perovskite of these characteristics is used in the electrochemical setup using a halogenated organic solvent in the absence of water. In particular, they use the perovskite MAPbI₃ (MA= methylammonium) in a dichloromethane solution and promote the reaction with different redox pairs such as Ferrocene/Ferrocenium or Benzoquinone/Benzoquinonium (Hsu, H.-Y.; Ji, L.; Du, M.; Zhao, J.; Yu, E. T.; Bard, A. J. Optimization of PbI2/MAPbI3 Perovskite Composites by Scanning Electrochemical Microscopy. The Journal of Physical Chemistry C 2016, 120 (35), 19890-19895). These works demonstrate the proof of concept that the photoelectrochemical setup is possible but does not solve the stability problems of the perovskite film in contact with the water. In fact, a perovskite film is dissolved in a matter of seconds in contact with water.

It should be recalled that the water used as a reaction medium is the preferred medium of industrial relevance. In these initial works, organic solvents have been used where the stability of these devices is greater than in water. However, even using non-aqueous solvents, stability has proven to continue being a real problem since, after operating for 20 hours, the devices are no longer capable of extracting photocurrent.

Setups can be found in the bibliography where protective films against water for different semiconductors are used. For example, amorphous carbon with low electrical conductivity has been used to protect different semiconductors such as CuO₂ nanowires or in silicon photovoltaic devices.

However, these protective films have not been used with hybrid (inorganic) perovskites. Furthermore, in order to protect perovskite photovoltaic devices from ambient humidity, a mixture of carbon black and graphite was deposited by screen printing and subjected to a heat treatment at 400°C for 30 minutes (Mei, A. et al. A hole-conductor-free, fully printable mesoscopic perovskite solar cell with high stability. Science 2014, 345 (6194), 295-298). The described processing gives rise to a conductive porous film that reduces degradation when exposed to ambient humidity, low concentrations of water in gaseous state, but which is ineffective against water in a liquid state. Thus, over time the pores allow water to penetrate up to the perovskite film and destroy it. Furthermore, a protective film based on an electrically conductive tape applied using a doctor blade has been used, which makes it possible to increase stability in the presence of ambient humidity (WO2016123407A1).

Lastly, films of hundreds of nanometres of composites formed by carbon nanotubes with highly conductive multilayers embedded in a semiconductive organic film (P3HT) to which a protective non-conductive film is added, for example, methyl polymethacrylate (Habisreutinger, S. N. et al. Carbon Nanotube/Polymer Composites as a Highly Stable Hole Collection Layer in Perovskite Solar Cells. Nano Letters 2014, 14 (10), 5561-5568) have been used. Electrical conductivity through the protective film is achieved using long carbon nanotubes, which may be hundreds of microns long. However, upon depositing the protective insulating film on top it is not deposited homogeneously and the carbon nanotubes penetrate the protective film, creating percolation paths. While this property enables electrical continuity, the presence of these holes which are necessary reduce long-term device stability. Additionally, due to the length of the carbon nanotubes, the devices have less mechanical stability and if the device is folded the perovskite film can be perforated, causing a short circuit. In the best-case scenario, the protective film reduces the efficiency of the devices, in which only 10-14% of efficiency is achieved, compared to the 21% that can be achieved in this type of devices.

Therefore, it is necessary to develop devices based on hybrid perovskite photovoltaic cells, but that include protective films against aqueous solvents in order to manufacture photoelectrochemical devices and be able to use them in solution, such as to obtain adequate performances and also to prevent the perovskite from becoming degraded or diluted over time.

### DESCRIPTION OF THE INVENTION

Surprisingly, the use of a protective film in an electrode of a photovoltaic device of the present invention that includes a catalyst makes it possible not only to prevent the perovskite film from becoming degraded or diluted over time, but also to obtain performances close to the maximum of the photovoltaic devices, and much longer use times than those shown in the bibliography for this type of devices.

Therefore, the first aspect of the present invention is an electrode for photoelectrochemical devices comprising
a) a film comprising perovskite with the general photovoltaic formula ABX₃, where
   A is an organic cation selected from among methylammonium, formamidinium, ethylammonium, propylammonium, n-butylammonium, isobutylammonium and benzylammonium; an inorganic cation selected from among Cs, Rb, K, Na and Li; or any combination thereof;
   B is a metal cation selected from among Pb, Sn, Bi, Nb and any combination thereof; and
   X is a halogen selected from among I, Br, Cl and any combinations thereof; and
b) a protective film of the film comprising perovskite, where said protective film comprises:
   - an electrically conductive material, and
   - a catalyst for the reaction in which the electrode participates.
      or
   - an electrically conductive material that is also a catalyst of the reaction in which the electrode participates;
   where said protective film has a thickness of at least 200 nm.

In the present invention, "perovskite with the general formula ABX₃" is understood to be a material with a perovskite-type crystal structure where the cell unit contains the cation A on the vertices of a cube, B is positioned in the center of the cube and X is positioned in the center of one of the sides of the cube, giving rise to octahedrons upon coordinating with B. Here the perovskite acts as a semiconductor capable of absorbing light, separating and transporting the charges, whether positive or negative.

In a preferred embodiment, A is methylammonium (MA).

In another preferred embodiment, B is lead (Pb).

In another preferred embodiment, X is iodine (I).

In a more preferred embodiment, the selected perovskite is an ABX₃ perovskite where A is methylammonium (MA), B is lead (Pb) and X is iodine (I), giving rise to the formula MAPbI₃.

The thickness of the perovskite layer is preferably between 50 nm and 1.5 microns. More preferably, said layer has a thickness of 350 nm.

In the present invention, "protective film" is understood to be that which comprises an electrically conductive material and optionally a catalyst for the reaction in which the electrode participates, or that which comprises a catalytic electrically conductive material for the reaction in which the electrode participates.

The electrically conductive material of which the protective film is composed may be any that creates a physical barrier between the perovskite film and the aqueous solution of the electrochemical device, such that said perovskite does not dissolve. Said electrically conductive material is hydrophobic and water-insoluble such as, for example, different varieties of carbon, metal films, conductive polymers with a high molecular weight (Mn>10000), conductive organic materials containing a small proportion of polar groups (<20 mol-%) such as the hydroxyl, carboxylic acid, amine, hydroxylamine groups composed of carbon-halogen chemical bonds. Preferably, the protective film will be composed of carbon or metals that are materially highly insoluble. This will make it possible to protect the perovskite film at ambient temperature and pressure in an aqueous solution medium, allowing the perovskite to permanently perform its photogeneration and load transport function. The importance of this protective film in the present invention is that it comprises a catalyst therein, where said catalyst may be located on the surface of the protective film or embedded in said film. This makes it possible to solve the stability problems of the perovskite film in aqueous solutions while conferring catalytic properties to carry out the desired electrochemical reactions. The electrically conducting material may act as a catalyst of the reaction in which the electrode participates.

In order to act as a protective layer, it must have a thickness of at least 200 nm. Preferably, the thickness of the protective layer varies between 200 nm and 1 cm, depending on the electrical conductivity of the protective layer, which must efficiently transport the current towards the catalytic layer. For example, for a protective metal with a very high conductivity (σ_{Cu}=5x10⁷ Sm⁻¹), the layer may have a thickness of up to 1 centimetre. Whereas in a less conductive material such as amorphous carbon (σ_{C}≈1x10⁴ Sm⁻¹), the thickness must be restricted to a range of between 200 nm and 10 µm.

Preferably, the electrically conductive material that comprises the protective film is selected from among the following list: Pt, Re, Pd, Ir, Rh, Ni, Co, W, Cu, Ru, Fe, Au, Ag, Mo, C, Nb, Cr, electrically conductive carbon tape, carbon black and any combination thereof. The electrical material may be used pure or in combination with a water-insoluble insulating material such as polyvinylidene fluoride (PVDF) or polyfluoroethylene (PTFE). More preferably, the electrically conductive material is carbon tape or a mixture comprising carbon black and polyvinylidene fluoride (PVDF). The following electrically conductive materials: Pt, Re, Pd, Ir, Rh, Ni, Co, W, Cu, Ru, Fe, Au, Ag, Mo, C, Nb, Cr or combinations thereof may also act as catalysts of the reaction.

In the event that the electrically conductive material of the protective film does not catalyse the reaction in which the electrode participates, the film will additionally comprise a catalyst for the aforementioned reaction.

Preferably, the catalyst that comprises the protective film is selected from among the following: Pt, Re, Pd, Ir, Rh, Ni, Co, C, W, MoS₂, Cu, Ru, Fe, Au, Ag, Mo, Nb, CoPi, NiP, MoP/S, IrOx, FeCoW, NiCoOx, CoOx, NiOx, IrOx, PtO₂, LaCrO₃, NiFeOx, CoFeOx, LaNiOx, LaFeO₃, LaMnO₃, Pd-Hg, Pt-Hg, Ag-Hg, Au and Cu-Hg. More preferably, the catalyst is Pt or NiCoOx.

The catalyst of the protective film can be found on the surface of said film or embedded therein.

In a preferred embodiment, the protective film comprises an electrically conductive carbon tape and a catalyst (which is found on the surface thereof, where said catalyst is selected from the following list comprising: Pt, Re, Pd, Ir, Rh, Ni, Co, C, W, MoS₂, Cu, Ru, Fe, Au, Ag, Mo, Nb, CoPi, NiP, MoP/S, IrOx, FeCoW, NiCoOx, CoOx, NiOx, IrOx, PtO₂, LaCrO₃, NiFeOx, CoFeOx, LaNiOx, LaFeO₃, LaMnO₃, Pd-Hg, Pt-Hg, Ag-Hg, Au and Cu-Hg. More preferably, the catalyst is Pt or NiCoOx and even more preferably NiCoOx.

In another preferred embodiment, the protective film comprises a catalyst embedded in a mixture formed by carbon black and polyvinylidene fluoride (PVDF). Said catalyst is preferably selected from the list comprising: Pt, Re, Pd, Ir, Rh, Ni, Co, W, MoS₂, Cu, Ru, Fe, Au, Ag, Mo, C, Nb, CoPi, NiP, MoP/S, IrOx, FeCoW, NiCoOx, CoOx, NiOx, IrOx, PtO₂, LaCrO₃, NiFeOx, CoFeOx, LaNiOx, LaFeO₃, LaMnO₃, Pd-Hg, Pt-Hg, Ag-Hg, Au and Cu-Hg. More preferably, the catalyst is NiCoOx.

Optionally, with the aim of improving its conductive and protective properties, the protective film may comprise, in addition to the electrically conductive material and the catalyst or the catalytic electrically conductive material, at least:
- one additional conductive metal film selected from the list consisting of: Pt, Re, Pd, Cr, Ir, Rh, Ni, Co, W, MoS₂, Cu, Ru, Fe, Au, Ag, Mo, Nb and any combination thereof, the metal conductor preferably being Au;
- an additional protective film without a catalyst; or
- combinations thereof.

Optionally, the electrode for a photoelectrochemical device of the present invention may comprise an adhesive film disposed on at least one of the following films: the film that comprises the perovskite, the protective film or on an additional protective film in the event that it is present in the device and where said adhesive film comprises an adhesive material and an electrically conductive material.

The adhesives will be selected in dry phase or with a very low solvent content. Acrylic adhesives in dry phase or epoxy adhesives with a low solvent content (<5%), in addition to pressure-sensitive adhesives (polyisobutylene), are particularly useful. Particles of any electrically conductive material with a small particle size (<100 nm) may be used as a conductive metal material. The following metals, for example, may be used: Pt, Re, Pd, Ir, Rh, Ni, Co, W, Cu, Ru, Fe, Au, Ag, Mo, C, Nb, Cr. Additionally, organic or inorganic conductive materials such as fluoride-doped titanium oxide (FTO), aluminium-doped zinc oxide (AZO), mixed antimony/tin oxide (ATO), a conductive polymer, a metal nanowire network with a diameter of less than 1 micron, nanotubes with a diameter of less than 1 micron or nanofilms with a thickness of less than 1 micron; a nanowire network with a diameter of less than 1 micron, nanotubes with a diameter of less than 1 micron or nanofilms with a thickness of less than 1 micron of carbon; graphene, silver nanowires with a diameter of less than 1 micron may be used. Formulations containing electrically conductive Cr/Cr₂O₃ particles <100 nm may be used.

Another preferred embodiment of the present invention is an electrode for photoelectrochemical device which also comprises:
i) a transparent material substrate selected from among: a glass selected from among soda-lime glass, silicon oxide glass, aluminoborosilicate glass and a plastic selected from among polyethylene terephthalate (PET), Poly-para-xylilene (for example, Parylene C) and transparent polyimides (for example, those derived from 2,2'-bis-(trifluoromethyl)-4,4'-diaminbiphenyl and 2,2-bis-(3,4-dicarboxyphenyl)hexafluoropropanedianhydride);
ii) a film, disposed on the substrate, comprising a conductive transparent material selected from the list consisting of: indium-doped tin oxide (ITO), fluoride-doped tin oxide (FTO), aluminium-doped zinc oxide (AZO), mixed antimony/tin oxide (ATO), a conductive polymer, a metal nanowire, nanotube or nanofilm network; a carbon nanowire, nanotube or nanofilm network; graphene, silver nanowires,
iii) a film, disposed on film (ii), comprising an electron transport layer (ETL) or a hole transport layer (HTL); and
iv) a film comprising a hole transport layer (HTL) in the event that film (iii) is an electron transport layer (ETL), or an electron transport layer (ETL) in the event that film (iii) is a hole transport layer (HTL);
where the film that comprises perovskite is disposed between films (iii) and (iv); and
where the protective film that comprises the electrically conductive material and the catalyst or the catalytic electrically conductive material, is disposed on film (iv).

In a preferred embodiment, the conductive transparent material substrate is fluoride-doped titanium oxide (FTO).

In another preferred embodiment, the conductive transparent material substrate selected is indium-doped tin oxide (ITO).

Preferably, the ETL is selected from the following list: zinc oxide (ZnO), aluminium-doped zinc oxide (AZO), mixed antimony-tin oxide (ATO), a conductive polymer, a metal nanowire, nanotube or nanofilm network; a carbon nanowire, nanotube or nanofilm network; graphene, silver nanowires, fullerene-C60, fullerene [6,6]fenil-C₆₁-butyric methyl ester acid (PCBM),1',1",4',4"-tetrahydro-di[1,4]methanenaphthalene [5,6]fullerene-C60(ICBA) and mesoporous titanium nanoparticles (TiO₂-ms) supported on a layer of compact titanium oxide (TiO₂-cp).

Preferably, the HTL is selected from the following list: 2,2',7,7'-Tetrakis[N,N-di(4-methoxyphenol)amine]-9,9'-spirobifluorene (Spiro-OMeTAD), nickel oxide (NiO), carbon, Poly(3,4-ethylenedioxythiophene)-poly(styrenesulfonate) (PEDOT:PSS), poly[bis(4-phenyl)(2,4,6-trimethylphenyl)amine] (PTAA), Poly-3-Hexylthiophene (P3HT), Poly(9,9-di-n-octylfluorenyl-2,7-diyl) (PFO-F8), Poly(2,5-bis(3-hexadecylthiophene-2-yl)thyene [3,2-b]thiophene (PBTTT), N,N'-Di(1-naphthyl)-N,N'-diphenyl-(1,1'-biphenyl)-4,4'-diamine (NPB or NPD), Poly[N,N'-bis(4-butylphenyl)-N,N'-bisphenylbenzidine] (PolyTPD), 4,4'-Bis(N-carbazolyl)-1,1'-biphenyl (CBP), 4,4',4"-Tris[(3-methylphenyl)phenylamine]triphenylamine (m-MTDATA).

In another preferred embodiment, film (iii), disposed on film (ii), is an ETL and, more preferably, is a film composed of titanium oxide nanoparticles (TiO₂-ms) supported on a compact titanium oxide film (TiO₂-cp). Even more preferably, said layer has a thickness of 200 nanometres.

In another preferred embodiment, film (iii), disposed on film (ii), is a HTL and, more preferably, is a Poly(3,4-etylenedioxythiophene)-poly(styrenesulfonate) (PEDOT:PSS) film.

In another preferred embodiment, film (iv) is a HTL and, more preferably, is Spiro-OMeTAD.

In another preferred embodiment, film (iv) is an ETL and, more preferably, is a fullerene film [6,6]phenyl-C₆₁-butyric methyl ester acid (PCBM).

In another more preferred embodiment, film (iii) is an ETL composed of titanium oxide nanoparticles (TiO₂-ms) supported on a compact titanium oxide film (TiO₂-cp) and film (iv) is a HTL de2,2',7,7'-Tetrakis[N,N-di(4-methoxyphenol)amine]-9,9'-spirobifluorene (Spiro-OMeTAD)

In another more preferred embodiment, the film (iii) is a HTL Poly(3,4-ethylenedioxythiophene)-poly(styrenesulfonate) (PEDOT:PSS) HTL film and the film (iv) is a ETL fullerene [6,6]phenyl-C₆₁-butyric methyl ester acid (PCBM).

In the event that the protective film comprises an additional protective film, it will be disposed next to the HTL or ETL film (iv).

In the event that the protective film comprises an additional conductive metal film, it will be disposed next to the HTL or ETL film (iv).

In the event that the protective film comprises an additional protective film and an additional conductive metal film, they will both be disposed next to the HTL or ETL film (iv), where the additional conductive metal film is in contact with the HTL or ETL film (iv).

In the present invention, "transparent material" that forms the substrate is that which lets white light pass through in order to use it to convert said light into electricity.

In the present invention, "conductive transparent material" is understood to be that which allows the passage of radiation associated with visible light in a percentage of more than 80% and that, at the same time, allows the transport of charge carriers.

In the present invention, "electron transport material (ETL)" is understood to be a material that enables the transport of electrons while blocking the transport of the positive charges from the perovskite film. The films formed by ETL preferably have a thickness between 50 nm and 300 nm.

In the present invention, "hole transport layer (HTL)" is understood to be a material which allows the transfer of positive charges while blocking the passage of negative charges from the perovskite film. The film formed by HTL preferably has a thickness between 20 nm and 100 nm.

In the present invention, "conductive polymer" is understood to be organic polymers that conduct electricity, either intrinsically, since they have conjugated double bonds, or if doped with materials containing an electronic excess or defect. Conductivity must be greater than 1x10⁻³ S/m.

In the present invention, "compact titanium oxide" is understood to be a poreless, compact, fine layer structure of crystallised anatase TiO₂. In the preferred setup, the thickness of this layer is between 20-50 nm.

In the present invention, "mesoporous titanium oxide" is understood to be a porous TiO₂ structure obtained from a precursor solution containing nanoparticles with a diameter comprised between 10-50 nm. A heat treatment ensures that the crystal structure of the nanoparticles is that of the anatase type and also eliminates the organic substances contained in the precursor solution, giving rise to pores. In the preferred setup, a 200-nanometer layer is used where the perovskite layer fills the pores, giving rise to a more stable perovskite.

In the present invention, NiCoOx, CoOx, NiOx, IrOₓ, NiFeOx, CoFeOx, LaNiOx, "NiCoOx" are non-stoichiometric oxides where there may be excess or shortage of oxygen.

In the present invention, "carbon tape" is understood to be a hydrophobic film composed mainly of carbon (>80%), which is electrically conductive. Electrical conductivity can be obtained through the high intrinsic conductivity of the carbon used; for example, there are commercial carbon tapes with high conductivity based exclusively on carbon, for example, the manufacturer Ted Pella distributes the product PELCO Tabs™, which have a laminar resistivity =50-200K Ω. Additionally, electrical conductivity can be achieved by embedding a metal mesh in a non-conductive carbon; for example, there are various commercial conductive materials that include nickel wires inside a layer of amorphous carbon. Commercial examples include the manufacturer 3M, Z-Axis Electrically Conductive Tape, with a laminar resistivity=0.001 Ω/sq, or the manufacturer Ted Pella, ConductiveLift-N-Press™, with a laminar resistivity=2 Ω/sq. The material ConductiveLift-N-Press™ was used for the proof of concept in the examples. This conductive tape is composed of highly conductive 50 nm carbon nanoparticles and has a metal content of 0.6% nickel and >0.3% Cu to improve conductivity. The resistance in the Z-axis that joins the perovskite film to the catalyst is 5 Ohm/cm. The carbon film has a thickness of 100 microns and has acrylic adhesive on both sides. The adhesive has an adhesive strength of 310 g/cm.

In the present invention, "nanowires" relates to materials with a compact cylindrical shape where the cylinder has a diameter of at least 20 nm and a length of at least 200 nm. The length will preferably be comprised between 200 nm and 10 microns. The length/diameter ratio is usually greater than 10.

In the present invention, "nanofilms" relates to materials with a film shape at nanometric scale where the material extends in two dimensions, while the thickness is at least ten times less than the length. Preferably, the thickness of the film will be at least 1 nm and the length in each of the dimensions (sides) at least 100 nm.

Another aspect of the present invention relates to a method for obtaining the photoelectrochemical device as defined in the first aspect of the present invention. Said method comprises the following steps:
a) Deposition of a conductive transparent material selected from among the following list consisting of: indium-doped tin oxide (ITO), fluoride-doped tin oxide (FTO), aluminium-doped zinc oxide (AZO), mixed antimony/tin oxide (ATO), a conductive polymer, a metal nanowire, nanotube or nanofilm network; a carbon nanowire, nanotube or nanofilm network; graphene, silver nanowires; on a transparent material substrate selected from the following list:
   a glass selected from among soda-lime glass, silicon oxide glass, aluminium oxide glass, aluminoborosilicate glass and a plastic selected from among polyethylene terephthalate (PET), Poly-para-xylylene (for example, Parylene C) and transparent polyimides (for example, those derived from 2,2'-bis-(trifluoromethyl)-4,4'-diaminebiphenyl and 2,2-bis-(3,4-dicarboxyphenyl)hexafluoropropanedianhydride);
b) Deposition of a hole transport layer (HTL) selected from the following list: 2,2',7,7'-Tetrakis[N,N-di(4-methoxyphenol)amine]-9,9'-spirobifluorene (Spiro-OMeTAD), nickel oxide (NiO), carbon, Poly(3,4-ethylenedioxythiophene)-poly(styrenesulfonate) (PEDOT:PSS), poly[bis(4-phenyl)(2,4,6-trimethylphenyl)amine] (PTAA), Poly-3-Hexylthiophene (P3HT), Poly(9,9-di-n-octylfluorenyl-2,7-diyl) (PFO-F8), Poly(2,5-bis(3-hexadecylthiophene-2-yl)thyene [3,2-b]thiophene (PBTTT), N,N'-Di(1-naphthyl)-N,N'-diphenyl-(1,1'-biphenyl)-4,4'-diamine (NPB or NPD), Poly[N,N'-bis(4-butylphenyl)-N,N'-bisphenylbenzidine] (PolyTPD), 4,4'-Bis(N-carbazolyl)-1,1'-biphenyl (CBP), 4,4',4"-Tris[(3-methylphenyl)phenylamine]triphenylamine (m-MTDATA);
   or
   an electron transport layer (ETL) selected from the following list: zinc oxide (ZnO), aluminium-doped zinc oxide (AZO), mixed antimony/tin oxide (ATO), a conductive polymer, a metal nanowire, nanotube or nanofilm network; a carbon nanowire, nanotube or nanofilm network; graphene, silver nanowires, fullerene-C60, fullerene [6,6]phenyl-C₆₁-butyric methyl ester acid (PCBM),1',1",4',4"-tetrahydro-di[1,4]methanenaphthalene [5,6]fullerene-C60(ICBA) and mesoporous titanium oxide nanoparticles (TiO₂-ms) supported on a compact titanium oxide layer (TiO₂-cp), on the conductive transparent material film deposited in step a);
c) Deposition of a perovskite film with the general photovoltaic formula ABX₃, where
   A is an organic cation selected from among methylammonium, formamidinium, ethylammonium, propylammonium, n-butylammonium, isobutylammonium and benzylammonium; an inorganic cation selected from among Cs, Rb, K, Na and Li or any combination thereof;
   B is a metal cation selected from among Pb, Sn, Bi, Nb and any combination thereof; and
   X is a halogen selected from among I, Br, Cl and any combinations thereof;
   on a hole transport layer (HTL) or an electron transport layer (ETL) deposited in step b).
d) Deposition of an electron transport layer (ETL) selected from the following list: zinc oxide (ZnO), aluminium-doped zinc oxide (AZO), mixed antimony/tin oxide (ATO), a conductive polymer, a metal nanowire, nanotube or nanofilm network; a carbon nanowire, nanotube or nanofilm network; graphene, silver nanowires, fullerene-C60, fullerene [6,6]phenyl-C₆₁-butyric methyl ester acid (PCBM),1',1",4',4"-tetrahydro-di[1,4]methanenaphthalene [5,6]fullerene-C60(ICBA) and mesoporous titanium oxide nanoparticles (TiO₂-ms) supported on a compact titanium oxide layer (TiO₂-cp) in the event that a hole transport layer (HTL) has been included in step b);
   or
   a hole transport layer (HTL) selected from the following list 2,2',7,7'-Tetrakis[N,N-di(4-methoxyphenyl)amine]-9,9'-spirobifluorene (Spiro-OMeTAD), nickel oxide (NiO), carbon, Poly(3,4-etylenedioxythiophene)-poly(styrenesulfonate) (PEDOT:PSS), poly[bis(4-phenyl)(2,4,6-trimethylphenyl)amine] (PTAA), Poly-3-Hexylthiophene (P3HT), Poly(9,9-di-n-octylfluorenyl-2,7-diyl) (PFO-F8), Poly(2,5-bis(3-hexadecylthiophene-2-il)thyene [3,2-b]thiophene (PBTTT), N,N'-Di(1-naphthyl)-N,N'-diphenyl-(1,1'-biphenyl)-4,4'-diamine (NPB or NPD), Poly[N,N'-bis(4-butylphenyl)-N,N'-bisphenylbenzidine] (PolyTPD), 4,4'-Bis(N-carbazolyl)-1,1'-biphenyl (CBP), 4,4',4"-Tris[(3-methylphenyl)phenylamine]triphenylamine (m-MTDATA); in the event that an electron transport layer (ETL) has been included on the perovskite layer deposited in step c);
e) deposition of a protective film comprising an electrically conductive material and a catalyst or a catalytic electrically conductive material, for the reaction in which the electrode participates, on the HTL or ETL film deposited in step d); the protective film may also comprise an additional conductive metal film, an additional protective film without a catalyst or combinations thereof;
f) optionally, deposition of an adhesive film disposed on the perovskite film of step c), the protective film deposited in step d) or on the additional conductive metal film of step e) and wherein said adhesive film is formed by a formulation containing an adhesive material and an electrically conductive material. The adhesives are selected in dry phase or with a very low solvent content. Particularly useful are acrylic adhesives in dry phase or epoxy adhesives with a low solvent content (<5%), also pressure-sensitive adhesives (polyisobutylene). Particles of any electrically conductive metal with a small particle size (<100 nm) may be used as a conductive metal material. The following metals, for example, may be used: Pt, Re, Pd, Ir, Rh, Ni, Co, W, Cu, Ru, Fe, Au, Ag, Mo, C, Nb and Cr. Additionally, conductive organic or inorganic materials may be used, such as fluoride (FTO), aluminium-doped zinc oxide (AZO), mixed antimony/tin oxide (ATO), a conductive polymer, a metal nanowire, nantube or nanofilm network; a carbon nanowire, nanotube or nanofilm network; graphene, silver nanowires. Formulations containing electrically conductive Cr/Cr₂O₃ particles <100 nm.

In a preferred embodiment of the method for obtaining the photoelectrochemical device, steps a), b) c), d), e) and f) of the method by means of a coating technique by centrifugation or using methods compatible with large-scale technology such as a doctor blade.

In another preferred embodiment, the method comprises preparing the protective and catalytic film, prior to deposition, following the steps below:
i Mixing carbon black as a conductive material in concentrations of 5-20% by weight, PVDF as a binder material in concentrations of 2-20% by weight, N-methyl-2-pyrrolidine as a solvent in concentrations of 70-90% and NiCoOx as a catalyst in concentrations of 0.001-5% by weight. More preferably, mixing 12% by weight of conductive material, carbon black, 7.8% by weight of the binder material, PVDF, 80% by weight of the solvent, N-methyl-2-pyrrolidine, and 0.2% by weight of the catalyst, NiCoOx.
ii Depositing the mixture obtained in i) using a doctor blade on a non-stick Teflon tape (FEP).
iii Evaporating the solvent of the product of step ii) in a vacuum oven at a temperature between 80-120°C for a time of between 11-13 hours.

Another aspect of the present invention relates to a photoelectrochemical device comprising an electrode such as that defined in the present invention.

Another aspect of the present invention relates to the use of the electrode defined in the present invention for carrying out oxidation-reduction chemical reactions in electrochemical setup such as the generation of hydrogen, generation of oxygen, oxygen reduction, oxidation of organic compounds such as methanol, generation of ammonia and generation of hydrogen peroxide. In the electrochemical setup, the device is in direct contact with a solution and, upon illuminating the semiconductor, an electrochemical reaction is promoted in the solution. There is a working electrode in which a certain redox reaction is carried out and a counter electrode (CE) where the complementary reaction for the given redox pair is carried out. For example, in the water-splitting reaction, oxygen is generated in one electrode and hydrogen is generated in the other electrode. That is, one electrode donates electrons to the chemical species in solution and the other donates positive charges to said species. If the working electrode, in which the perovskite semiconductor is integrated, carries out the oxidation reaction, the CE will carry out the reduction reaction and vice versa. Thus, the reaction that takes place to generate hydrogen in an acid medium is 2H⁺+2e⁻→H₂ and the water-splitting reaction generates oxygen following the reaction 2H₂O →O₂ + 4H⁺+ 4e⁻. Likewise, the electrode of the present invention may be used in other reactions such as, for example: in the oxygen reduction reaction (O₂+4H⁺+4e⁻→2H₂O), in the production of hydrogen peroxide (O₂+2H⁺+2e⁻→H₂O₂), in the reduction of carbon dioxide (CO₂ + ne⁻+ mH⁺→ hydrocarbons + H₂O), in the nitrogen reduction reaction (N₂+6H⁺ +6e⁻→ 2NH₃) and in the oxidation of organic compounds such as methanol (CH₃OH + 3H₂O → 2CO₂ + 12e⁻ + 12H⁺).

Throughout the description and claims, the word "comprises" and its variants do not intend to exclude other technical characteristics, additives, components or steps. For the persons skilled in the art, other objects, advantages and characteristics of the invention shall be partly inferred from the description and partly from the practice of the invention. The following examples and figures are provided by way of illustration and are not intended to be limiting of the present invention.

### BRIEF DESCRIPTION OF THE FIGURES

Figure 1 shows the photoelectrochemical device with a protective film with a catalyst on its surface.
Figure 2 shows the photoelectrochemical device with a protective film with a catalyst embedded in said protective film.

### EXAMPLES

The invention is illustrated below by means of assays conducted by the inventors, which demonstrate the application and stability of the photoelectrochemical cells of the present invention.

### Example 1: Preparation and characterisation of photoelectrodes with configuration 1 for the oxygen evolution reaction. Glass/FTO/TiO₂-ct-/TiO₂-ms/MAPbI₃/S_{P}iro-OMeTAd/Protective film: Au/carbon tape /NiCoOx)

The photoelectrodes (Glass/FTO/TiO₂-ct/TiO₂-ms/MAPbI₃/Spiro-OMeTad/Au) are prepared on glass containing FTO. The substrates are washed with soap, rinsed with deionised water, ethanol and dried using compressed air. The TiO₂-cp film is deposited on the substrates by means of spray pyrolysis at 450°C, using a titanium diisopropoxide bis(acetylacetonate) solution diluted in ethanol (1:9, v/v). Spraying is performed in three, 6-second steps, spraying 5 mL at a time and waiting for 30 s between the steps. The substrates were maintained at 450°C for 30 minutes. The TiO₂-mesoporous film is deposited by centrifugation at 33 Hz for 10 s using a commercial nanoparticle paste TiO₂ (Solaronix, particle diameter = 17 nm) diluted in ethanol (proportion by weight of 1:5). Next, it is dried at 100°C for 10 minutes, the substrate is heated at 500°C for 30 minutes and is then cooled at room temperature. The perovskite precursor solution is prepared reacting DMF solutions containing methylammonium (MAI), lead iodide (PbI₂) and dimethylsulfoxide (DMSO) in the molar ratio 1:1:1 to give a final concentration of 1.2 moles/L. The perovskite precursor solution (50 µL) is deposited by centrifugation at 66 Hz for 50 s. The DMF is selectively washed with diethyl ether (0.5 mL), while centrifugation at 66 Hz is carried out. After the deposition, the substrate is heated at 100°C for 180 s. Next, the perovskite films are covered with the positive charge transport material (HTL) by centrifugation at 66Hz for 30 s, using 50 µL of spiro-OMeTAD solution. By way of additional electrically conductive material, 60 nm of gold are thermally evaporated on the upper part of the device to form the electrode contacts using a thermal evaporation chamber.

Commercial carbon conductive tape (Ted Pella, ConductiveLift-N-Press™) is used as the electrically conductive material of the protective film. This layer is composed of highly conductive 50 nm carbon nanoparticles and has a metal content of 0.6% nickel and >0.3% Cu to improve conductivity. The resistance in the Z-axis that joins the perovskite film with the catalyst is 5 Ohm/cm. The thickness of the carbon film is 100 microns and has acrylic adhesive on both sides. The adhesive has an adhesive strength of 310 g/cm. A catalyst for the production of oxygen in an aqueous medium is added by evaporation of a solution containing the catalyst. In this process 5 mg of NiCoOx (nanoparticles<150 nm, Sigma-Aldrich) are dispersed in 1 mL of methanol using an ultrasound bath for 5 minutes. 100 µL of this solution are added to 1 cm² of the side of the carbon film exposed to air, which contains acrylic adhesive, and left to evaporate. The coating of the catalytic film provides films with a catalyst density of 0.5 mg/cm². This process can be easily upscaled to industrial scale using, for example, roll-to-roll or slot die methods.

Photoelectrochemical characterisation is carried out using a basic aqueous solution (pH=11) containing NaOH (1 M) illuminated by a Xe lamp at an intensity of 100 mW/cm². A three-electrode setup is used in which the reference is Ag/AgCl and the counter electrode is a platinum wire. The device makes it possible to produce water oxidation currents in the perovskite electrode and generation of oxygen of 1 mA/cm⁻² at an applied potential of 0.85 V (vs RHE). Stability in water is maintained for more than 48 hours at 0.85 V (vs RHE).

### Example 2: Comparative example in which a multifilm carbon composite with the semiconductor P3HT as a protective film without including a catalyst is used: Glass/FTO/TiO₂-ct--TiO₂-ms/MAPbI₃/Spiro-OMeTAd/Au/P3HT

The photoelectrode is prepared as in example 1 in the Glass/FTO/TiO₂-ct/TiO₂-ms/MAPbI₃/Spiro-OMeTAd/Au setup. Additionally, a carbon nanotube composite with highly conductive multifilms embedded in an organic semiconductive film (P3HT) was used. The production and deposition process is described below. The carbon nanotubes (Aldrich) have lengths of 0.5-10 µm and a distribution with an intermediate diameter of 4-15 nm with a carbon percentage of >90%. 3 mg of Poly 3-Hexylthiophene (P3HT, Lumtech, Mw = 50.000 g·mol⁻¹ and regioregularity = 95%) are dissolved in 5ml of chlorobenzene, sonicating in a sonication bath for 60 min. 2.5 mg of the carbon nanotubes were added to the solution and the dispersion was treated in an ultrasound probe for 10 min. The mixture was subjected to a centrifugation process for 8 min at 125 Hz to remove the non-functionalised nanotubes and other carbonaceous particles. The precipitate was discarded and the supernatant was used as a precursor solution of the protective film. The precursor solution (200 µL) of the protective film is deposited by centrifugation at 50 Hz for 2 minutes. Poly(methyl methacrylate) (50 mg/ml in toluene) is deposited by spin coating at 33Hz for 60 s.

Photoelectrochemical characterisation is carried out using a basic aqueous solution (pH=11) containing NaOH (1 M) illuminated with a Xe lamp at an intensity of 100 mW/cm². A three-electrode setup is used where the reference is Ag/AgCl and the counter electrode is a platinum wire. The device does not produce significant currents in the order of mA/cm⁻² at voltages comprised between 0-2.0 V (vs RHE).

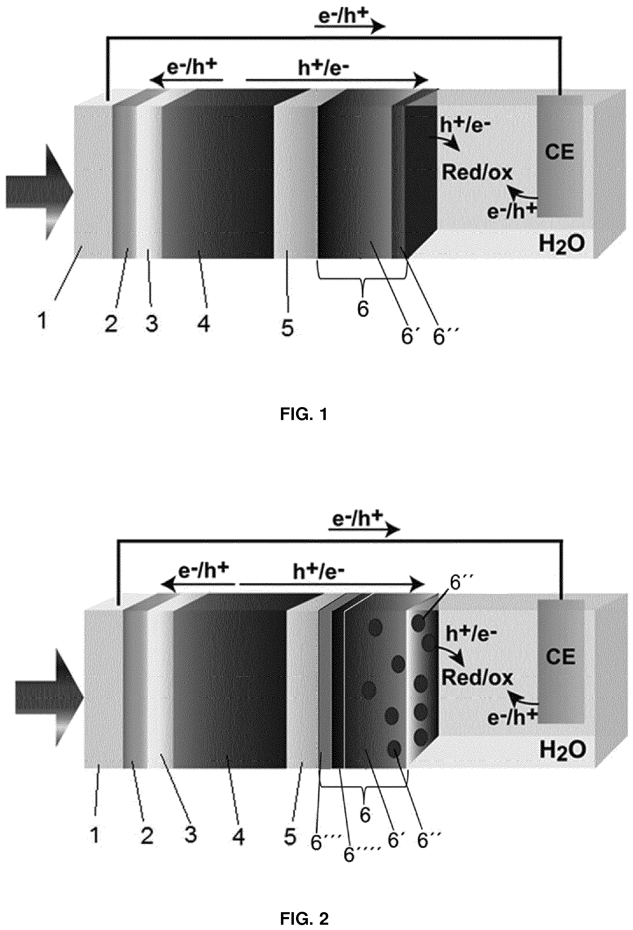

### Example 3: Preparation and characterisation of photoelectrodes with configuration 2 for the oxygen evolution reaction. (Glass (1)/FTO(2)/TiO₂-ct/TiO₂-ms(3)/MAPbI₃(4)/Spiro-OMeTAD(5)/Protective film (6): Au (6"')/carbon tape (6'''')/adhesive/catalyst embedded (6") in an electrically conductive material (6'), Figure 2.

The following photoelectrode layers: Glass/FTO/TiO2-ct/TiO2-ms/MAPbI₃/Spiro-OMeTad/Au are prepared as in example 1.

To prepare the protective film with an embedded catalyst: the following are mixed in an agate mortar: carbon black (Alpha Aesar, Acetylenic, 3 g), poly(vinylidene fluoride) (PVDF, 2 g) and cobalt oxide and nickel with a particle size <150 nm (Sigma-Aldrich, 634360, 50 mg) with 20 mL of N-methyl-2-pyrrolidine (NMP). The solution is deposited using a doctor blade on a fluorated Teflon non-stick tape (FEP). The doctor blade conditions are adjusted to provide a film with a thickness of 100 microns. The solvent is evaporated in a vacuum oven at 100°C for 12 h. This composition provides a content in catalyst of 1% by weight and a film with a laminar resistance of 50 Ohm squared measured using the Van der Pauw method, which are adequate results for enabling the film to be protective, electrically conductive and catalytic.

The preparation of the adhesive film: the device is completed using an acrylic-based adhesive with a polar solvent content of less than <5% mixed with 2 g of the adhesive with 3 g of Cr:Cr₂O₃ nanoparticles (25 nm, Sigma-Aldrich) for 1 hour.

To assemble the different films: an adhesive film is applied on an additional carbon tape, waiting 3 minutes for the curing process to begin. After this time, the photoelectrode is lightly pressed and, against the adhesive film, the conductive material film with an embedded catalyst. This process can be easily upscaled to industrial scale using roll-to-roll, slot die or doctor blade methods.

The photoelectrochemical characterisation is carried out using a basic aqueous solution (pH=11) containing NaOH (1 M). The device is illuminated with a Xe lamp at an intensity of 100 mW/cm². A three-electrode setup is used where the reference is Ag/AgCl and the counter electrode is a platinum wire. The device makes it possible to produce water oxidation currents and oxygen generation of 0.8 mA/cm⁻² in the perovskite electrode at an applied potential of 0.8 V (vs RHE) under the action of the light. Stability in water is maintained for more than 120 hours at 0.8 V (vs RHE).

### Example 4: Preparation and characterisation of photoelectrodes in configuration 1 for the generation of hydrogen: (Glass/FTO/PEDOT:PSS/MAPbI₃/PCBM//protective film: Au/Carbon tape (100 microns)/Pt

The glass/FTO photoelectrodes are washed with soap, rinsed with deionised water, ethanol and dried with compressed air. Next, a 50 nm layer of the commercial conductive polymer PEDOT:PSS (Clevios, Al4083) is deposited by centrifugation at 88Hz for 1 minute. The substrate is heated at 120°C for 10 minutes. The perovskite layer is deposited as in example 1. The fullerene is dissolved PC60BM (Nano-C) in chlorobenzene (20 mg/mL) and deposited by centrifugation at 63Hz for 2 minutes on the perovskite film.

The additional metal conductor, Au, is deposited by thermal deposition in a vacuum as in example 1.

The commercial carbon conductive tape (Ted Pella, ConductiveLift-N-Press™) is used as a protective film as in example 1. Next, a Pt catalyst adequate for carrying out the proton reduction reaction in an aqueous solution to produce hydrogen is deposited. A Baltec spray metal coater (Sputtering SCD 500) is used which is capable of generating a thin platinum film using a current of 50 mA, maintaining the distance between the Pt source and the substrates at approximately 5 cm at a basic pressure of 5.10⁻⁴ mbar. This provides a thickness of approximately 0.5 nm in accordance with the calibration curve provided by the manufacturer.

The photoelectrochemical characterisation is carried out using an acid aqueous solution (pH=1) containing H₂SO₄ (0.5 M) illuminating with a Xe lamp at an intensity of 100 mW/cm². A three-electrode setup is used where the reference is Ag/AgCl and the counter electrode is a platinum wire. The device makes it possible to produce proton reduction currents in the perovskite for the generation of hydrogen under illumination of 5 mA/cm⁻² at an applied potential of +0.2 V (vs RHE). Stability in water is maintained for more than 30 minutes at +0.2V (vs RHE).

### Example 5: Comparative example without using a protective film (Glass/FTO/PEDOT:PSS/MAPbI₃/PCBM/Au/Pt)

The photoelectrode is manufactured as in example 4 but the Pt film is deposited directly on the photoelectrode without using the protective carbon film. Characterisation is attempted using the same methods as in example 4. The device is degraded during the first minute in contact with water, being impossible to assemble the photoelectrochemical cell and obtain photocurrent. In contact with water the semiconductive MAPbI₃ film is degraded, leaving as solid residue the PbI₂ material, which is an inadequate insulating material for the proposed application. This example shows that a conductive material with a thickness of less than 200 nm is ineffective to protect the perovskite layer.

### Example 6: Preparation and characterisation of photoelectrodes in configuration 1 for the generation of hydrogen: (Glass (1)/FTO(2)/PEDOT:PSS(3)/MAPbI₃(4)/PCBM(5)/Protective film (6): Carbon tape(100 microns)(6')/Pt(6")). This embodiment is shown in figure 1.

The following photoelectrode layers: Glass/FTO/PEDOT:PSS/MAPbI₃/PCBM are prepared as described in example 4. In this case, Au is not deposited to demonstrate that the electrode can be simplified in certain cases.

A protective film is deposited on this photoelectrode as detailed in example 4. Photoelectrochemical characterisation is carried out as detailed in example 4. The device can produce water oxidation currents and generate oxygen of 800 µA/cm⁻² at an applied potential of +0.2 V (vs RHE). Stability in water is maintained for more than 1 hour at +0.2V (vs RHE).

### Example 7: Preparation and characterisation of photoelectrodes in configuration 1 for methanol oxidation: (Glass/FTO/TiO₂-ct/TiO₂-ms/MAPbI₃/Spiro-OMeTAd/Protective film: Au/Carbon tape /NiCoOx

The photoelectrode and catalyst are prepared as in example 1.

Photoelectrochemical characterisation is carried out using a solution containing NaOH (1 M) in dry methanol illuminating with a Xe lamp at an intensity of 100 mW/cm². A three-electrode setup is used where the reference is Ag/AgCl and the counter electrode is a platinum wire. The device can produce methanol oxidation currents in the perovskite electrode of 1.01mA/cm⁻² at an applied potential of 0.65 V (vs RHE). Stability in the basic methanol solution is maintained for more than 2 hours at 0.65 V (vs RHE).

## Claims

1. An electrode for a photoelectrochemical device comprising
a) a film comprising perovskite with the general photovoltaic formula ABX₃, where
A is an organic cation selected from among methylammonium, formamidinium, ethylammonium, propylammonium, n-butylammonium, isobutylammonium and benzylammonium; an inorganic cation selected from among Cs, Rb, K, Na and Li; or any combination thereof;
B is a metal cation selected from among Pb, Sn, Bi, Nb and any combination thereof; and
X is a halogen selected from among I, Br, Cl and any combinations thereof; and
b) a protective film of the film comprising perovskite, where said protective film comprises:
- an electrically conductive material, and
- a catalyst for the reaction in which the electrode participates;
or
- an electrically conductive material that is also a catalyst of the reaction in which the electrode participates;
where said protective film has a thickness of at least 200 nm.

2. The electrode for a photoelectrochemical device, according to claim 1, which also comprises:
i) a substrate of transparent material selected from among: a glass selected from among soda and lime, silicon oxide glass, aluminium oxide glass, aluminoborosilicate glass; a plastic selected from among polyethylene terephthalate, poly-para-xylylene and polyamides;
ii) a film, disposed on the substrate, comprising a transparent conductive material selected from the list consisting of: indium-doped tin oxide, fluoride-doped tin oxide, aluminium-doped zinc oxide, mixed antimony/tin oxide, a conductive polymer, a metal nanowire, nanotube or nanofilm network; a carbon nanowire, nanotube or nanofilm network; graphene and silver nanowires;
iii) a film, disposed on film (ii), which comprises an electron transport layer (ETL);
or
a hole transport layer (HTL); and
iv) a film comprising a negative charge transport layer (HTL) in the event that film (iii) is an electron transport film (ETL)
or
an electron charge transport layer (ETL) in the event that film (iii) is a positive charge transport film (HTL);
where the film comprising perovskite is disposed between films (iii) and (iv); and where the protective film is disposed on film (iv).

3. The electrode for a photoelectrochemical device, according to claim 2, where film (ii), which comprises a transparent conductive material, is fluoride-doped tin oxide.

4. The electrode for a photoelectrochemical device, according to any of the preceding claims, where A is methylammonium, B is lead and X is iodine, in the ABX₃ perovskite.

5. The electrode for a photoelectrochemical device, according to any of claims 2 to 4, where the negative charge transport layer (ETL) is selected from the following list consisting of: zinc oxide, aluminium-doped zinc oxide, mixed antimony/tin oxide, a conductive polymer, a metal nanowire, nanotube or nanofilm network; a carbon nanowire, nanotube or nanofilm network; graphene, silver nanowires, fullerene-C60, fullerene, [6,6]phenyl-C61-butyric methyl ester acid, 1',1",4',4"-tetrahydro-di[1,4]methanenaphthalene [5,6]fullerene-C60 and mesoporous titanium oxide nanoparticles supported on a compact titanium oxide layer;
and/or where
the hole transport layer (HTL) is selected from the list consisting of: 2,2',7,7'-Tetrakis[N,N-di(4-methoxyphenol)amine]-9,9'-spirobifluorene, nickel oxide, carbon, Poly(3,4-ethylenedioxythiophene)-poly(styrenesulfonate), poly[bis(4-phenyl)(2,4,6-trimethylphenyl)amine], poly-3-hexylthiophene, Poly(9,9-di-n-octylfluorenyl-2,7-diyl), Poly(2,5-bis(3-hexadecylthiophene-2-yl)thyene[3,2-b]thiophene, N,N'-Di(1-naphthyl)-N,N'-diphenyl-(1,1'-biphenyl)-4,4'-diamine, Poly[N,N'-bis(4-butylphenyl)-N,N'-bisphenylbenzidine], 4,4'-Bis(N-carbazolyl)-1,1'-biphenyl, 4,4',4"-Tris[(3-metylphenyl) phenylamine]triphenylamine;

6. The electrode for a photoelectrochemical device, according to any of the preceding claims, where the protective film comprises an electrically conductive material and a catalyst for the reaction in which the electrode participates, where said catalyst is disposed on the protective film surface or embedded in said protective film.

7. The electrode for a photoelectrochemical device, according to any of the preceding claims, where the protective film comprises an electrically conductive material and a catalyst for the reaction in which the electrode participates, where said electrically conductive material is an electrically conductive carbon tape.

8. The electrode for a photoelectrochemical device, according to claim 6 or 7, where the catalyst is disposed on the surface of the protective film and is selected from among: Pt, Re, Pd, Ir, Rh, Ni, Co, W, MoS₂, Cu, Ru, Fe, Au, Ag, Mo, Nb, CoPi, NiP, MoP/S, IrOx, FeCoW, NiCoOx, CoOx, NiOx, IrOx, PtO₂, LaCrO₃, NiFeOx, CoFeOx, LaNiOx, LaFeO₃, LaMnO₃, Pd-Hg, Pt-Hg, Ag-Hg, Au and Cu-Hg.

9. The electrode for a photoelectrochemical device, according to any of claims 1 to 6, where the protective film comprises:
- an electrically conductive material where the electrically conductive material comprises carbon black,
- polyvinylidene fluoride, and
- an embedded catalyst for the reaction in which the electrode participates.

10. The electrode for a photoelectrochemical device, according to claim 9, where the catalyst of the protective film is embedded therein and is selected from among the following: Pt, Re, Pd, Ir, Rh, Ni, Co, W, MoS₂, Cu, Ru, Fe, Au, Ag, Mo, Nb, CoPi, NiP, MoP/S, IrOx, FeCoW, NiCoOx, CoOx, NiOx, IrOx, PtO₂, LaCrO₃, NiFeOx, CoFeOx, LaNiOx, LaFeO₃, LaMnO₃, Pd-Hg, Pt-Hg, Ag-Hg, Au and Cu-Hg.

11. The electrode for a photoelectrochemical device, according to any of the preceding claims, where the protective film additionally comprises a conductive metal film where said metal conductor is selected from the list consisting of Pt, Re, Pd, Cr, Ir, Rh, Ni, Co, W, Cu, Ru, Fe, Au, Ag, Mo, Nb and any combination thereof.

12. The electrode for a photoelectrochemical device, according to any of the preceding claims, where the protective film comprises an additional protective film without a catalyst.

13. The electrode for a photoelectrochemical device, according to any of the preceding claims, comprising an adhesive film disposed on at least one of the following films: the film comprising the perovskite, the protective film or on an additional protective film, where said adhesive film comprises an adhesive material and an electrically conductive material.

14. A photoelectrochemical device comprising an electrode such as that defined in any of the preceding claims.

15. Use of the electrode defined in any of claims 1 to 13 or of the device according to claim 14 for carrying out a reaction selected from the list comprising: generation of hydrogen, generation of oxygen, generation of hydrogen peroxide, water-splitting reaction, oxygen reduction, nitrogen reduction and oxidation of organic compounds.
